# EUROPEAN PATENT APPLICATION

(11) **EP 4 779 879 A1**
(43) Date of publication of application: **22.07.2026**
(21) Application number: 26151079.6
(22) Date of filing: 09.01.2026
(51) Int. Cl.: H04B 1/401, H01Q 21/24

(54) **PHASE ARRAY ANTENNA DEVICE AND ANTENNA UNIT THEREOF**

(30) Priority: 15.01.2025 US 202563745402 P
(71) Applicant: Phasetrum Inc., Taipei City 104 (TW)
(72) Inventor: TSAI, Zuo-Min, 104 Taipei City (TW); TSAI, Chung-Wang, 104 Taipei City (TW)
(74) Representative: Karakatsanis, Georgios

(57) **Abstract**

An antenna unit includes an antenna radiation element (15) and a polarization selection circuit (14). The polarization selection circuit (14) is configured to selectively convert an input signal to a first output signal (S6) and/or a second output signal (S7). The first output signal (S6) and/or the second output signal (S7) is fed to the antenna radiation element (15) so as to generate linearly polarized electromagnetic waves or circularly polarized electromagnetic waves which are radiated out by the antenna radiation element (15). The first output signal (S6) and the second output signal (S7) have a first phase difference therebetween that is fixed at a specific value between 0-180°.

## Description

### BACKGROUND OF THE INVENTION

### Field of the Invention

The invention relates to a phase array antenna device and the antenna unit thereof.

### Description of the Related Art

A phased array antenna device has plural antenna elements arranged into an antenna array and disposed on a plane. Different antenna elements are configured to radiate signals with different phase shifts, so that the wave front of the superposed electromagnetic waves is deviated from the plane at a deflection angle (beam angle) and the radiated signals are directional. By varying the phase of the signals radiated from each antenna elements, the deflection angle can be varied and the electromagnetic waves can be radiated in different directions without any physical movement of the antenna elements.

Generally, the signals radiated by an array antenna device are either linearly polarized or circularly polarized, and the polarization pattern cannot be changed in one hardware structure. Specifically, a linear polarization array antenna can only radiate linearly polarized signals, and a circular polarization array antenna can only radiate circularly polarized signals. A vertical linear polarization array antenna can not radiate horizontal linear polarization signal and vice versa. A Left hand circular polarization array antenna can not radiate right hand circular signal and vice versa.

### BRIEF SUMMARY OF THE INVENTION

In view of the above-mentioned issue, the invention correspondingly provides a phased array antenna device and the antenna unit thereof. In the invention, phased array antenna devices which have the same hardware structure can be selectively set as different polarization types of array antenna devices to meet different requirements. In other words, different polarization types of array antenna devices can be obtained by simply setting the phased array antenna devices of the invention. Therefore, the phased array antenna device of the invention has a wide range of applications and is competitive in the market.

The antenna unit in accordance with an exemplary embodiment of the invention includes includes an antenna radiation element and a polarization selection circuit. The polarization selection circuit is configured to selectively convert an input signal to a first output signal and/or a second output signal. The first output signal and/or the second output signal is fed to the antenna radiation element so as to generate linearly polarized electromagnetic waves or circularly polarized electromagnetic waves which are radiated out by the antenna radiation element. The first output signal and the second output signal have a first phase difference therebetween that is fixed at a specific value between 0-180°.

In another exemplary embodiment, the first phase difference is substantially 90°.

In yet another exemplary embodiment, the polarization selection circuit includes two variable gain amplifiers, a signal coupler and two power amplifiers. The signal coupler is configured for receiving first intermediate signals from the variable gain amplifiers, generating second intermediate signals by mixing the first intermediate signals, and transmitting the second intermediate signals to the power amplifiers. The variable gain amplifiers are configured for receiving the input signal, and performing amplitude weighting thereby controlling the second intermediate signals to have a second phase difference corresponding to the first phase difference. The power amplifiers are configured for receiving the second intermediate signals from the signal coupler, compensating for signal loss, and generating the first output signal and/or the second output signal which is fed to the antenna radiation element.

In another exemplary embodiment, the second phase difference is substantially 90°.

In yet another exemplary embodiment, the variable gain amplifiers include a first variable gain amplifier and a second variable gain amplifier. The power amplifiers include a first power amplifier and a second power amplifier. The first variable gain amplifier, the second variable gain amplifier and the first power amplifier are configured to be on or enabled, while the second power amplifier is configured to be off or disabled, so that horizontally polarized electromagnetic waves are radiated out by the antenna radiation element.

In another exemplary embodiment, the variable gain amplifiers include a first variable gain amplifier and a second variable gain amplifier. The power amplifiers include a first power amplifier and a second power amplifier. The first variable gain amplifier, the second variable gain amplifier and the second power amplifier are configured to be on or enabled, while the first power amplifier is configured to be off or disabled, so that vertically polarized electromagnetic waves are radiated out by the antenna radiation element.

In yet another exemplary embodiment, the variable gain amplifiers include a first variable gain amplifier and a second variable gain amplifier. The power amplifiers include a first power amplifier and a second power amplifier. The first variable gain amplifier, the first power amplifier and the second power amplifier are configured to be on or enabled, while the second variable gain amplifier is configured to be off or disabled, so that left-hand circularly polarized electromagnetic waves are radiated out by the antenna radiation element.

In another exemplary embodiment, the variable gain amplifiers include a first variable gain amplifier and a second variable gain amplifier. The power amplifiers include a first power amplifier and a second power amplifier. The second variable gain amplifier, the first power amplifier and the second power amplifier are configured to be on or enabled, while the first variable gain amplifier is configured to be off or disabled, so that right-hand circularly polarized electromagnetic waves are radiated out by the antenna radiation element.

In yet another exemplary embodiment, the polarization selection circuit includes a first variable gain amplifier, a second variable gain amplifier, a third variable gain amplifier, a fourth variable gain amplifier and a signal coupler. The signal coupler is configured for receiving first intermediate signals from the first variable gain amplifier and the second variable gain amplifier, generating second intermediate signals by mixing the first intermediate signals, and transmitting the second intermediate signals to the third variable gain amplifier and the fourth variable gain amplifier. The first variable gain amplifier and the second variable gain amplifier are configured for receiving the input signal, and performing amplitude weighting thereby controlling the second intermediate signals to have a second phase difference corresponding to the first phase difference. The third variable gain amplifier and the fourth variable gain amplifier are configured for receiving the second intermediate signals from the signal coupler, compensating for signal loss, and generating the first output signal and/or the second output signal which is fed to the antenna radiation element. The third variable gain amplifier and the fourth variable gain amplifier are further configured for adjusting compensation for the signal loss.

In another exemplary embodiment, the second phase difference is substantially 90°.

In yet another exemplary embodiment, the first variable gain amplifier, the second variable gain amplifier and the third variable gain amplifier are configured to be on or enabled, while the fourth variable gain amplifier is configured to be off or disabled, so that horizontally polarized electromagnetic waves are radiated out by the antenna radiation element.

In another exemplary embodiment, the first variable gain amplifier, the second variable gain amplifier and the fourth variable gain amplifier are configured to be on or enabled, while the third power amplifier is configured to be off or disabled, so that vertically polarized electromagnetic waves are radiated out by the antenna radiation element.

In yet another exemplary embodiment, the first variable gain amplifier, the third variable gain amplifier and the fourth variable gain amplifier are configured to be on or enabled, while the second variable gain amplifier is configured to be off or disabled, so that left-hand circularly polarized electromagnetic waves are radiated out by the antenna radiation element.

In another exemplary embodiment, the second variable gain amplifier, the third variable gain amplifier and the fourth variable gain amplifier are configured to be on or enabled, while the first variable gain amplifier is configured to be off or disabled, so that right-hand circularly polarized electromagnetic waves are radiated out by the antenna radiation element.

The invention also provides a phased array antenna device. The phased array antenna device in accordance with an exemplary embodiment of the invention includes a plurality of above-mentioned antenna units. The antenna units are arranged into an array. The antenna units include a plurality of polarization selection circuits and a plurality of antenna radiation elements corresponding to the polarization selection circuits. The antenna radiation elements are configured to radiate out the linearly polarized electromagnetic waves or circularly polarized electromagnetic waves with different electronic field oscillation directions.

A detailed description is given in the following embodiments with reference to the accompanying drawings.

### BRIEF DESCRIPTION OF THE DRAWINGS

The invention can be more fully understood by reading the subsequent detailed description and examples with references made to the accompanying drawings, wherein:
Fig. 1 is a block diagram of a phased array antenna device in accordance with the invention.
Fig. 2 is a circuit diagram of a polarization selection circuit and an antenna radiation element in accordance with a first embodiment of the invention.
Fig. 3 is a circuit diagram of a polarization selection circuit and an antenna radiation element in accordance with a second embodiment of the invention.

### DETAILED DESCRIPTION OF THE INVENTION

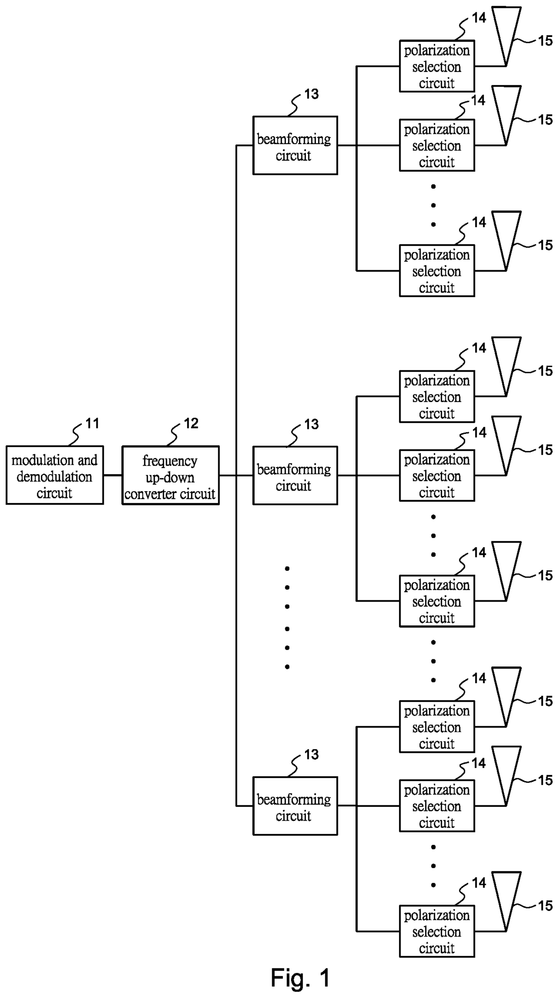

Referring to Fig. 1, a phased array antenna device of the invention includes a modulation and demodulation circuit 11, a frequency up-down converter circuit 12, a plurality of beamforming circuits 13, a plurality of polarization selection circuits 14, and a plurality of antenna radiation elements 15.

The modulation and demodulation circuit 11 is configured for modulating a high frequency carrier wave with a low frequency message signal which is to be transmitted. The frequency up-down converter circuit 12 is configured for increasing (up-converting) the frequency of the signal. The beamforming circuit 13 is configured for evenly distributing the power of the signal, generating input signals which have different phases, and transmitting the input signals to the polarization selection circuits 14. Each of the polarization selection circuits 14 is configured for amplifying an input signal and generating desired output signals with the amplitude and/or phase thereof adjusted for beam forming. The desired output signals are fed to the antenna radiation elements 15. The antenna radiation elements 15 are arranged into an array for radiating linearly polarized electromagnetic waves or circularly polarized electromagnetic waves with different electronic field oscillation directions. The modulation and demodulation circuit 11, the frequency up-down converter circuit 12, and the beamforming circuits 13 are prior art and therefore the detailed descriptions thereof are omitted.

In Fig. 1, a combination of one polarization selection circuit 14 and one antenna radiation element 15 may be considered an antenna unit, and a plurality of antenna units are correspondingly provided for one beamforming circuit 13. For different beamforming circuits 13, the number of the corresponding antenna units may be same or different, which depends on the requirements of design. It is understood that both the same number of antenna units and different number of antenna units belong to the category of the invention.

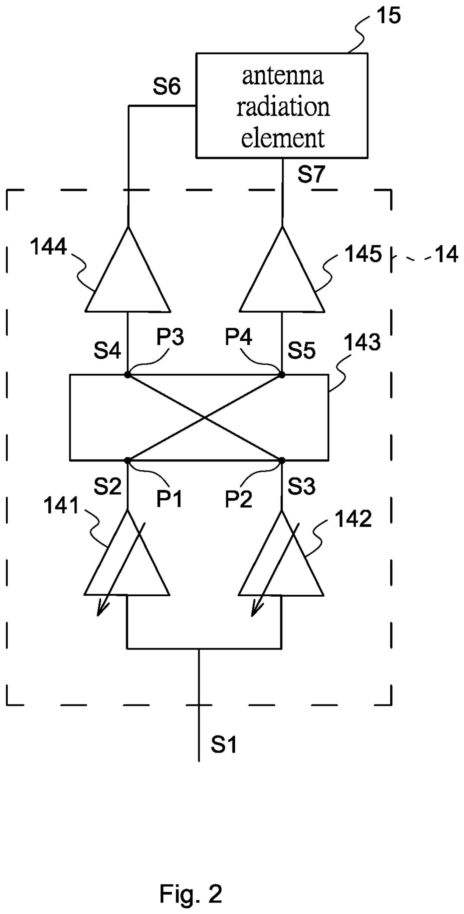

As described above, the phased array antenna device of the invention can be set as different polarization types of array antenna device (linearly polarized or circularly polarized). For easy understanding, one antenna unit is introduced as a representative. Referring to Fig. 2, Fig. 2 is a circuit diagram of a polarization selection circuit and an antenna radiation element in accordance with a first embodiment of the invention. As shown, the polarization selection circuit 14 includes a variable gain amplifier 141, a variable gain amplifier 142, a signal coupler 143, a power amplifier 144 and a power amplifier 145, described in detail as below.

The signal coupler 143 is configured for receiving the first intermediate signals S2, S3 from the variable gain amplifiers 141, 142, mixing the first intermediate signals S2, S3, and transmitting the second intermediate signals S4, S5 to the power amplifiers 144, 145. In the first embodiment, the signal coupler 143 is a directional coupler and includes two input ports P1, P2 and two output ports P3, P4. The input ports P1, P2 are coupled to the output ports P3, P4 through different transmission paths, so that the second intermediate signals S4, S5 can be a linear combination of the first intermediate signals S2, S3. For example, the second intermediate signal S4 has a part from the first intermediate signal S2 and another part from the first intermediate signal S3, and the second intermediate signal S5 has another part from the first intermediate signal S2 and another part from the first intermediate signal S3.

The variable gain amplifiers 141, 142 are configured for receiving the input signal S1 and performing amplitude weighting, thereby controlling the second intermediate signals S4, S5 to have a substantially 90° phase difference therebetween. Specifically, the variable gain amplifiers 141, 142 have the gains which are adjustable so as to control the amplitudes of the first intermediate signals S2, S3, and further to control the phase difference between the second intermediate signals S4, S5 to be substantially 90°.

The power amplifiers 144, 145 are configured for receiving the second intermediate signals S4, S5 from the signal coupler 143, compensating for the signal loss by signal amplification, and generating the first output signal S6 and the second output signal S7 which has a phase difference of substantially 90°. The first output signal S6 and the second output signal S7 are fed to the antenna radiation element 15.

The antenna radiation element 15 is configured for receiving the first output signal S6 and the second output signal S7 and radiating out the corresponding polarized electromagnetic waves.

It is worth noting that the antenna radiation element 15 is able to radiate out either linearly polarized electromagnetic waves or circularly polarized electromagnetic waves by setting the operation mode of the polarization selection circuit 14 of the invention in accordance with different requirements.

### First Operation Mode

When the first operation mode is set, the variable gain amplifier 141, the variable gain amplifier 142 and the power amplifier 144 of the polarization selection circuit 14 are configured to be on or enabled, and the power amplifier 145 is configured to be off or disabled. A first output signal S6 is transmitted from the power amplifier 144 to the antenna radiation element 15. No signal is transmitted out from the power amplifier 145. The antenna radiation element 15 radiates out horizontally polarized electromagnetic waves, the electric field of which is parallel to the ground.

### Second Operation Mode

When the second operation mode is set, the variable gain amplifier 141, the variable gain amplifier 142 and the power amplifier 145 of the polarization selection circuit 14 are configured to be on or enabled, and the power amplifier 144 is configured to be off or disabled. A second output signal S7 is transmitted from the power amplifier 145 to the antenna radiation element 15. No signal is transmitted out from the power amplifier 144. The antenna radiation element 15 radiates out vertically polarized electromagnetic waves, the electric field of which is perpendicular to the ground.

### Third Operation Mode

When the third operation mode is set, the variable gain amplifier 141, the power amplifier 144 and the power amplifier 145 of the polarization selection circuit 14 are configured to be on or enabled, and the variable gain amplifier 142 is configured to be off or disabled. A first output signal S6 is transmitted from the power amplifier 144 to the antenna radiation element 15. Also, a second output signal S7 is transmitted from the power amplifier 145 to the antenna radiation element 15. The antenna radiation element 15 radiates out left-hand circularly polarized electromagnetic waves, in which the electric field vector rotates in a left-hand sense with respect to the direction of propagation.

### Fourth Operation Mode

When the fourth operation mode is set, the variable gain amplifier 142, the power amplifier 144 and the power amplifier 145 of the polarization selection circuit 14 are configured to be on or enabled, and the variable gain amplifier 141 is configured to be off or disabled. A first output signal S6 is transmitted from the power amplifier 144 to the antenna radiation element 15. Also, a second output signal S7 is transmitted from the power amplifier 145 to the antenna radiation element 15. The antenna radiation element 15 radiates out right-hand circularly polarized electromagnetic waves, in which the electric field vector rotates in a right-hand sense with respect to the direction of propagation.

The above-mentioned four operation modes can be expressed in the following table, wherein symbol 1 denotes "on" or "enabled", and symbol 0 denotes "off" or "disabled".

| | variable gain amplifier 141 | variable gain amplifier 142 | power amplifier 144 | power amplifier 145 | electromagnetic waves |
|---|---|---|---|---|---|
| 1^{st} operation mode | 1 | 1 | 1 | 0 | horizontally polarized |
| 2^{nd} operation mode | 1 | 1 | 0 | 1 | Vertically polarized |
| 3^{rd} operation mode | 1 | 0 | 1 | 1 | left-hand circularly polarized |
| 4^{th} operation mode | 0 | 1 | 1 | 1 | right-hand circularly polarized |

For example, the first operation mode can be set by a manufacturer to obtain a linear polarization type of array antenna device. In the first operation mode, the variable gain amplifier 141, the variable gain amplifier 142 and the power amplifier 144 of the polarization selection circuit 14 are enabled (or are on during operation), the power amplifier 145 is disabled (or is off during operation), and the phased array antenna device radiates out linearly polarized electromagnetic waves. For another example, the third operation mode can be set by the manufacturer to obtain a left-hand circular polarization type of array antenna device. In the third operation mode, the variable gain amplifier 141, the power amplifier 144 and the power amplifier 145 of the polarization selection circuit 14 are enabled (or are on during operation), the variable gain amplifier 142 is disabled (or is off during operation), and the phased array antenna device radiates out left-hand circularly polarized electromagnetic waves. In conclusion, by simply changing the settings, the phased array antenna devices of the invention that have the same hardware structure can function as different polarization types of array antenna devices to meet market requirements. Therefore, the phased array antenna devices of the invention have a wide range of applications and are commercially competitive.

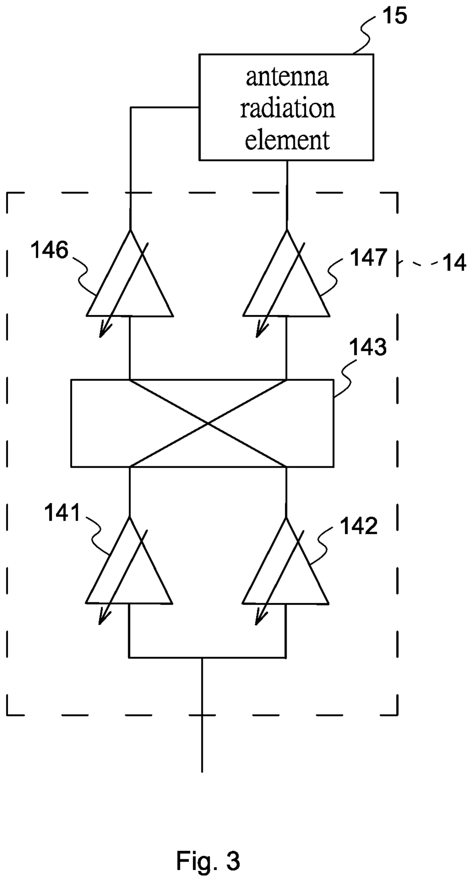

Fig. 3 is a circuit diagram of a polarization selection circuit and an antenna radiation element in accordance with a second embodiment of the invention, wherein the elements same as those of the first embodiment are indicated with the same symbols and the descriptions thereof are omitted. The second embodiment differs from the first embodiment in that the power amplifiers 144, 145 for compensation of signal loss in the first embodiment are replaced with variable gain amplifiers 146, 147 in the second embodiment. The gains of the variable gain amplifiers 146, 147 are adjustable so that the signal loss can be properly compensated according to the practical demands.

In the above-mentioned embodiments, the first output signal S6 and the second output signal S7 fed to the antenna radiation element 15 have a substantially 90° phase difference therebetween. However, the invention is not limited thereto. For example, the first output signal S6 and the second output signal S7 have a first phase difference therebetween. In the invention, the first phase difference is not limited to 90° but may be fixed at a specific value between 0-180°. Further, the second intermediate signals S4, S5 have a second phase difference therebetween. It is required that the second phase difference is determined and provided corresponding to the first phase difference.

What is described above is only the preferred embodiment of the invention, and the scope of the invention is not limited thereto. That is, the simple equivalent changes and modifications made according to the description of the invention and the claims are all within the scope of the invention. Further, any one of the embodiments or claims is not required to achieve all the objects or advantages or features of the invention. Further, the abstract and title are only used to assist in the search of patent documents and are not intended to limit the scope of the invention. Further, the terms "first" and "second" described in the specification and claims are only used to distinguish between different elements, embodiments or scopes, without limiting the quantity of the elements with an upper limit or a lower limit.

## Claims

1. An antenna unit, comprising:
an antenna radiation element (15);
a polarization selection circuit (14) configured to selectively convert an input signal (S1) to a first output signal (S6) and/or a second output signal (S7);
wherein the first output signal (S6) and/or the second output signal (S7) is fed to the antenna radiation element (15) so as to generate linearly polarized electromagnetic waves or circularly polarized electromagnetic waves which are radiated out by the antenna radiation element (15);
wherein the first output signal (S6) and the second output signal (S7) have a first phase difference therebetween that is fixed at a specific value between 0-180°.

2. The antenna unit as claimed in claim 1, wherein the first phase difference is substantially 90°.

3. The antenna unit as claimed in claim 1, wherein:
the polarization selection circuit (14) comprises two variable gain amplifiers (141, 142), a signal coupler (143) and two power amplifiers (144, 145);
the signal coupler (143) is configured for receiving first intermediate signals (S2, S3) from the variable gain amplifiers (141, 142), generating second intermediate signals (S4, S5) by mixing the first intermediate signals (S2, S3), and transmitting the second intermediate signals (S4, S5) to the power amplifiers (144, 145);
the variable gain amplifiers (141, 142) are configured for receiving the input signal (S1), and performing amplitude weighting thereby controlling the second intermediate signals (S4, S5) to have a second phase difference corresponding to the first phase difference;
the power amplifiers (144, 145) are configured for receiving the second intermediate signals (S4, S5) from the signal coupler (143), compensating for signal loss, and generating the first output signal (S6) and/or the second output signal (S7) which is fed to the antenna radiation element (15).

4. The antenna unit as claimed in claim 3, wherein the second phase difference is substantially 90°.

5. The antenna unit as claimed in claim 3, wherein:
the variable gain amplifiers comprise a first variable gain amplifier (141) and a second variable gain amplifier (142);
the power amplifiers comprise a first power amplifier (144) and a second power amplifier (145);
the first variable gain amplifier (141), the second variable gain amplifier (142) and the first power amplifier (144) are configured to be on or enabled, while the second power amplifier (145) is configured to be off or disabled, so that horizontally polarized electromagnetic waves are radiated out by the antenna radiation element (15).

6. The antenna unit as claimed in claim 3, wherein:
the variable gain amplifiers comprise a first variable gain amplifier (141) and a second variable gain amplifier (142);
the power amplifiers comprise a first power amplifier (144) and a second power amplifier (145);
the first variable gain amplifier (141), the second variable gain amplifier (142) and the second power amplifier (145) are configured to be on or enabled, while the first power amplifier (144) is configured to be off or disabled, so that vertically polarized electromagnetic waves are radiated out by the antenna radiation element (15).

7. The antenna unit as claimed in claim 3, wherein:
the variable gain amplifiers comprise a first variable gain amplifier (141) and a second variable gain amplifier (142);
the power amplifiers comprise a first power amplifier (144) and a second power amplifier (145);
the first variable gain amplifier (141), the first power amplifier (144) and the second power amplifier (145) are configured to be on or enabled, while the second variable gain amplifier (142) is configured to be off or disabled, so that left-hand circularly polarized electromagnetic waves are radiated out by the antenna radiation element (15).

8. The antenna unit as claimed in claim 3, wherein:
the variable gain amplifiers comprise a first variable gain amplifier (141) and a second variable gain amplifier (142);
the power amplifiers comprise a first power amplifier (144) and a second power amplifier (145);
the second variable gain amplifier (142), the first power amplifier (144) and the second power amplifier (145) are configured to be on or enabled, while the first variable gain amplifier (141) is configured to be off or disabled, so that right-hand circularly polarized electromagnetic waves are radiated out by the antenna radiation element (15).

9. The antenna unit as claimed in claim 1, wherein:
the polarization selection circuit (14) comprises a first variable gain amplifier (141), a second variable gain amplifier (142), a third variable gain amplifier (146), a fourth variable gain amplifier (147) and a signal coupler (143);
the signal coupler (143) is configured for receiving first intermediate signals (S2, S3) from the first variable gain amplifier (141) and the second variable gain amplifier (142), generating second intermediate signals (S4, S5) by mixing the first intermediate signals (S2, S3), and transmitting the second intermediate signals (S4, S5) to the third variable gain amplifier (146) and the fourth variable gain amplifier (147);
the first variable gain amplifier (141) and the second variable gain amplifier (142) are configured for receiving the input signal (S1), and performing amplitude weighting thereby controlling the second intermediate signals (S4, S5) to have a second phase difference corresponding to the first phase difference;
the third variable gain amplifier (146) and the fourth variable gain amplifier (147) are configured for receiving the second intermediate signals (S4, S5) from the signal coupler (143), compensating for signal loss, and generating the first output signal (S6) and/or the second output signal (S7) which is fed to the antenna radiation element (15);
the third variable gain amplifier (146) and the fourth variable gain amplifier (147) are further configured for adjusting compensation for the signal loss.

10. The antenna unit as claimed in claim 9, wherein the second phase difference is substantially 90°.

11. The antenna unit as claimed in claim 9, wherein the first variable gain amplifier (141), the second variable gain amplifier (142) and the third variable gain amplifier (146) are configured to be on or enabled, while the fourth variable gain amplifier (147) is configured to be off or disabled, so that horizontally polarized electromagnetic waves are radiated out by the antenna radiation element (15).

12. The antenna unit as claimed in claim 9, wherein the first variable gain amplifier (141), the second variable gain amplifier (142) and the fourth variable gain amplifier (147) are configured to be on or enabled, while the third variable gain amplifier (146) is configured to be off or disabled, so that vertically polarized electromagnetic waves are radiated out by the antenna radiation element (15).

13. The antenna unit as claimed in claim 9, wherein the first variable gain amplifier (141), the third variable gain amplifier (146) and the fourth variable gain amplifier (147) are configured to be on or enabled, while the second variable gain amplifier (142) is configured to be off or disabled, so that left-hand circularly polarized electromagnetic waves are radiated out by the antenna radiation element (15).

14. The antenna unit as claimed in claim 9, wherein the second variable gain amplifier (142), the third variable gain amplifier (146) and the fourth variable gain amplifier (147) are configured to be on or enabled, while the first variable gain amplifier (141) is configured to be off or disabled, so that right-hand circularly polarized electromagnetic waves are radiated out by the antenna radiation element (15).

15. A phased array antenna device, comprising:
a plurality of antenna units as claimed in any one of claims 1-14, arranged into an array;
wherein the antenna units comprise a plurality of polarization selection circuits (14) and a plurality of antenna radiation elements (15) corresponding to the polarization selection circuits (14);
wherein the antenna radiation elements (15) are configured to radiate out the linearly polarized electromagnetic waves or circularly polarized electromagnetic waves with different electronic field oscillation directions.
